Europäisches Patentamt

(19) European Patent Office

Office européen des brevets

(11) Numéro de publication: **0 106 740**
**B1**

(12) **FASCICULE DE BREVET EUROPEEN**

(45) Date de publication du fascicule du brevet:
**20.11.86**

(51) Int. Cl.⁴: **H 03 B 5/18**

(21) Numéro de dépôt: **83401835.0**

(22) Date de dépôt: **20.09.83**

(54) Oscillateur hyperfréquence de puissance.

(30) Priorité: **24.09.82 FR 8216158**

(43) Date de publication de la demande:
**25.04.84 Bulletin 84/17**

(45) Mention de la délivrance du brevet:
**20.11.86 Bulletin 86/47**

(84) Etats contractants désignés:
**DE GB IT NL SE**

(56) Documents cités:
**EP - A - 0 017 562**
**DE - A - 2 536 151**
**FR - A - 2 124 353**
**US - A - 4 234 854**
**US - A - 4 311 965**

**THE INSTITUTE OF ELECTRICAL AND ELECTRONIC ENGINEERS, INC. - INTERNATIONAL MICROWAVE SYMPOSIUM DIGEST, San Diego, CA, 21-23 juin 1977, IEEE International microwave symposium, Piscataway (US). Y. MITSUI et al.: "Design of GaAs MESFET oscillator using large signal s-parameters", pages 270-272**
**MICROWAVE JOURNAL, vol. 25, no. 3, mars 1982, Dedham, Mass. (US). J. M. SCHELLENBERG et al.: "A new approach to FET power amplifiers", pages 51-66**

(73) Titulaire: **THOMSON-CSF, 173, Boulevard Haussmann, F-75379 Paris Cedex 08 (FR)**

(72) Inventeur: **Bert, Alain, THOMSON-CSF SCPI 173, bld Haussmann, F-75379 Paris Cedex 08 (FR)**

(74) Mandataire: **Taboureau, James et al, THOMSON-CSF SCPI 19, avenue de Messine, F-75008 Paris (FR)**

(56) Documents cités: (suite)
**MICROWAVE JOURNAL, vol. 21, no. 10, octobre 1978, Dedham, Mass. (US). H. ABE: "Dielectric resonator stabilization", pages 65-66**

## Description

La présente invention concerne un oscillateur hyperfréquences de puissance, synchronisable, constitué par une pluralité de transistors à effet de champ montés en parallèle. Elle concerne également deux réalisations de cet oscillateur de puissance, l'une en technologie linéaire, l'autre en technologie circulaire. L'oscillateur de puissance selon l'invention constitue une source de puissance pour l'émission en hyperfréquences, pour les dispositifs de télécommunication ou de radar par exemple.

Dans les techniques de radar ou de télécommunication, lorsqu'il s'agit d'émettre sur des distances importantes, il est nécessaire de disposer de sources hyperfréquences de puissance. De telles sources sont généralement obtenues soit à partir d'une source de plus faible puissance amplifiée au niveau désiré, soit à partir d'un oscillateur de puissance synchronisé par un oscillateur à plus bas niveau. Pour des ordres de grandeur supérieurs à 10 Watts, en bandes X ou Ku, les composants les plus utilisés pour l'étage de puissance sont des tubes ou des diodes à avalanche. La technologie des tubes est ancienne, elle présente des avantages, mais n'est pas homogène avec les technologies actuelles des semiconducteurs. Les diodes à avalanche, du fait que ce sont des dipôles, ne sont pas directement commandables et synchronisables.

L'invention concerne la réalisation d'un oscillateur de puissance, synchronisable, comportant un grand nombre de transistors élémentaires du type à effet de champ. Le remplacement selon l'invention des dipôles que sont les diodes par des quadrupôles que sont les transistors, non seulement facilite la synchronisation des différents dispositifs semiconducteurs constituant l'oscillateur, qui génère ainsi une onde plus pure, mais elle permet en outre:

– une réalisation selon une plus large gamme de topologies possibles, compte-tenu de ce que l'élément oscillant est un quadrupôle actif et non plus un dipôle

– une plus faible tension d'utilisation

– un rendement intéressant, car les diodes à avalanche nécessitent généralement l'introduction d'une résistance en série dans le circuit de polarisation pour éviter des phénomènes s'oscillation en basse fréquence

– un comportement moins critique en fonction des conditions de charge et de polarisation.

Il est connu qu'un transistor à effet de champ monté en drain commun oscille à une fréquence contrôlée par la partie imaginaire de l'impédance introduite sur sa grille. Des oscillateurs très stables en fréquence sont ainsi obtenus en rendant l'impédance sélective en fréquence, par exemple par couplage de la grille à un résonateur diélectrique, qui peut être isolé en continu du drain: la grille s'autopolarise, et il suffit d'alimenter la source sous polarisation négative.

Le montage en parallèle d'une pluralité de semblables oscillateurs pose des problèmes de synchronisation et de phase, en raison des très hautes fréquences concernées par les oscillateurs selon l'invention, fréquences qui se comptent en GHz. C'est pourquoi des résistances, reliant entre elles les grilles d'une part, les sources d'autre part permettent à la fois d'équilibrer les transistors et de supprimer les modes d'oscillation parasites.

De façon plus précise, l'invention concerne un oscillateur hyperfréquence de puissance, constitué par une pluralité d'oscillateurs élémentaires couplés en parallèle, caractérisé en ce que chaque oscillateur élémentaire comporte un transistor à effet de champ, monté en drain commun à la masse, la source étant reliée à la charge utile commune par l'intermédiaire d'un tronçon de ligne permettant d'effectuer l'adaptation d'impédance, la grille étant réunie à une ligne microbande de longueur quart d'onde $\lambda_g/4$, les lignes microbandes de grille des oscillateurs élémentaires étant réunies entre elles par leur extrémité opposée à celle qui est reliée à la grille, les lignes microbandes de source étant réunies entre elles par leur extrémité opposée à celle qui est reliée à la source, ladite extrémité constituant la sortie de l'oscillateur de puissance, des résistances connectées entre grilles et des résistances connectées entre sources, servant à l'équilibrage et à la suppression des oscillations parasites.

L'invention sera mieux comprise par la description suivante, accompagnée de deux exemples de réalisation, cette description s'appuyant sur les figures annexes qui concernent:

– figure 1: schéma électrique d'une cellule oscillatrice selon l'art connu

– figure 2: montage d'un transistor à effet de champ oscillateur, grille couplée à un résonateur diélectrique, selon l'art connu

– figure 3: schéma électrique d'un oscillateur de puissance à deux transistors à effet de champ selon l'invention

– figure 4: généralisation du schéma précédent à n transistors à effet de champ

– figure 5: exemple de réalisation linéaire d'un oscillateur selon l'invention

– figure 6: exemple de couplage de plusieurs oscillateurs linéaires selon la figure 5

– figure 7 et 8: exemple de réalisation en topologie circulaire d'un oscillateur selon l'invention, vu en plan (figure 7) et en coupe (figure 8).

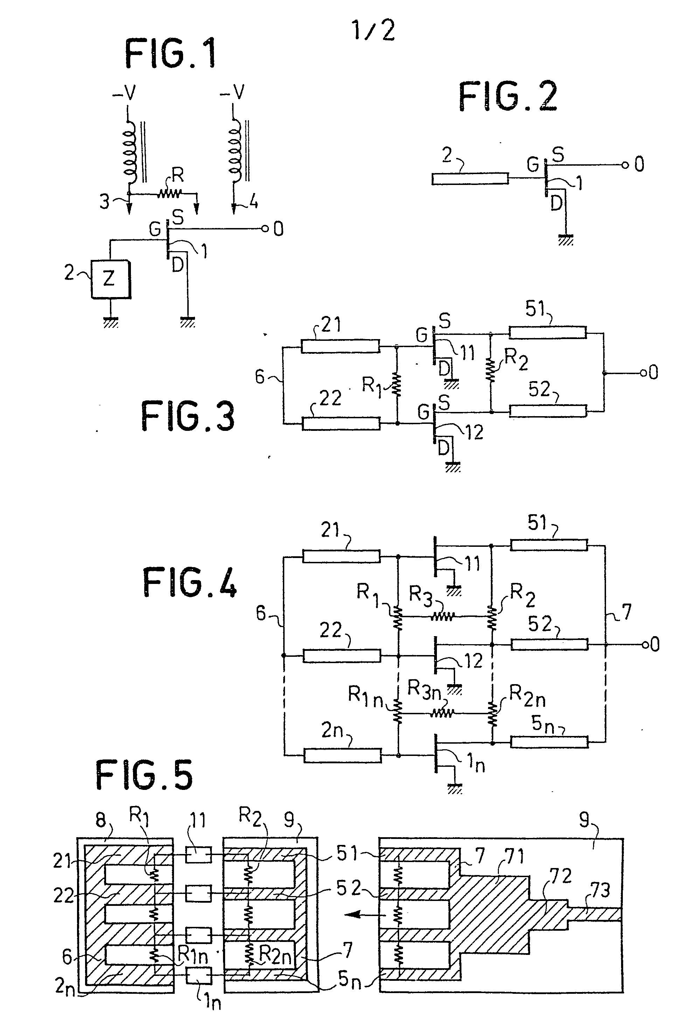

La figure 1 représente le schéma d'une cellule oscillatrice à transistors à effet de champ selon l'art connu. Selon cette figurée, le transistor à effet de champ 1 est monté en drain commun c'est-à-dire que le drain D est la masse, la sortie se fait par la source S, et la grille G est chargée par une impédance Z. L'alimentation ou la polarisation d'une telle cellule oscillatrice peut se faire de deux façons. Dans un premier cas, une alimentation négative – V, est appliquée en 3 sur la grille G du tansistor 1 et, à travers une résistance est appliquée également sur la source S du transistor. Dans un second cas, une tension – V est appliquée en 4 sur la source seulement, et pour une charge de sortie convenable la grille s'auto-polarise. Etant donné qu'il est possible de polariser un transistor à effet de champ selon deux façons et deux configurations, on conviendra sur les figures suivantes de ne pas représenter la façon dont est polarisé le (ou les) transistor(s) de la figure.

Le choix de l'impédance Z, introduite sur la grille et représentée par un bloc diagramme 2 sur la figure 1, permet de faire apparaître une résistance négative aux bornes de sortie du transistor. Il y a donc possibilité d'apparitions d'oscillations entretenues sur charges réelles. On sait qu'avec un tel circuit la fréquence d'oscillation est essentiellement contrôlée par la partie imaginaire de l'impédance Z. Les oscillateurs très stables en fréquence peuvent ainsi être obtenus en rendant Z sélectif en fréquences, par exemple par couplage de la grille à un résonateur diélectrique. Un fonctionnement particulièrement intéressant est celui selon lequel la grille est électriquement isolée du drain en continu, sans être reliée à aucune polarisation: pour une charge de sortie convenable, la grille s'autopolarise à une valeur voisine de $I_{DSS/2}$. Il suffit alors de polariser la source négativement. La figure 2 donne un exemple de réalisation d'une telle cellule oscillatrice, dans laquelle l'impédance appliquée sur la grille est isolée électriquement du drain: dans ce cas, l'impédance Z est elle ramenée par un tronçon de microbande terminé en circuit ouvert à l'extrémité opposée à celle qui est réunie à la grille du transistor à effet de champ. La sortie de cette cellule oscillatrice est représentée par la borne O, qui reçoit une charge active.

La figure 3 représente le schéma électrique d'un oscillateur de puissance à deux transistors à effet de champ selon l'invention. Comme il a été dit, la polarisation des transistors, qui peut se faire de deux façons différentes, n'est pas représentée sur cette figure.

Pour chacun des transistors à effet de champ constituant l'oscillateur l'impédance de grille Z est obtenue grâce à une ligne microbande dont l'autre extrémité est en circuit ouvert, et la source est reliée à la charge utile par l'intermédiaire d'une autre ligne microbande. Typiquement, ces lignes ont des longueurs voisines d'un quart de longueur d'onde. Ainsi, le transistor 11 est chargé sur sa grille G par une ligne microbande 21 et sa source S est reliée à la sortie O à travers une ligne microbande 51; de même pour le transistor 12, il est chargé par une impédance 22 sur sa grille et sa source est reliée à la sortie O par une ligne microbande 52. Les drains des deux transistors sont montés à la masse.

Pour assurer le couplage des cellules élémentaires oscillatrices, d'une part les impédances Z ramenées par les lignes 21 et 22 montées sur la grille des transistors sont réunies entre elles par leur extrémité libre, et de même les lignes microbandes 51 et 52 branchées entre les sources et la sortie sont réunies entre elles et ont une sortie commune. D'autre part des résistances d'équilibrage $R_1$ et $R_2$ sont montées: $R_1$ entre les deux grilles des transistors, et $R_2$ entre les deux sources des transistors.

Cette structure active comporte un mode symétrique et un mode antisymétrique. Toute oscillation antisymétrique, y compris une oscillation éventuelle sur le mode antisymétrique, est annulée grâce à la présence des résistances $R_1$ et $R_2$, qui jouent à la fois le rôle de résistance d'équilibrage et de suppression de mode parasite. Ainsi, pour le mode symétrique tout se passe comme si l'on avait deux oscillateurs du type de la figure 2 montés strictement en parallèle et équilibrés. Pour le mode antisymétrique, les résistances $R_1$ et $R_2$ le suppriment, et le couplage en parallèle des cellules oscillatrices assure donc un fonctionnement régulier, équilibré et synchronisable, uniquement sur le mode symétrique.

Une structure comparable à celle du schéma de la figure 3 est connue du document Microwave Journal, vol. 25, numéro 3, mars 1982, pages 51–66. Mais, le dispositif décrit dans ce document est un amplificateur, pour lequel on recherche la stabilité, obtenue en montage source commune. En effet, monter la source à la masse empêche un transistor à effet de champ d'osciller, tandis que monter le drain à la masse, en montage drain commun, amène une contreréaction interne au transistor à effet de champ, et crée l'oscillation du circuit, si les impédances d'entrées et de sorties sont correctement adaptées.

La figure 4 correspond à la généralisation du schéma précédent, avec n transistors à effet de champ, dans le but d'obtenir une puissance rayonnée plus importante. Le nombre de transistors représentés sur cette figure 4, de même que sur les figures suivantes, ne constitue pas une limitation au domaine de l'invention, qui peut selon la technologie utilisée pour la réalisation regrouper par exemple 10 transistors associés en parallèle. Le petit nombre de transistors représentés sur cette figure de même que sur les figures suivantes n'a pour objet que de simplifier les figures.

Sur la figure 4, est apportée une modification par rapport à la figure 3, cette modification étant constituée par la présence des résistances $R_3$ à $R_{3n}$. Pour chaque cellule oscillatrice de l'ensemble de la figure 4, la résistance $2R_3 + \dfrac{R1 + R2}{2}$ correspond à la résistance R de polarisation, telle qu'elle est représentée sur la figure 1 par le cas de polarisation repéré 3, c'est-à-dire lorsque la polarisation $-V$ est appliquée à la fois sur la grille, et sur la source du transistor à travers une résistance R. Par conséquent, si le schéma de la figure 4 est alimenté de cette façon, des résistances $R_3$ sont interconnectées entre les résistances d'équilibrage et de suppression de modes parasites $R_1$ et $R_2$. Si par contre le schéma de la figure 4 est alimenté par une tension $-V$ appliquée directement sur les sources, les résistances $R_3$ n'ont pas lieu d'être et sont supprimées du schéma.

En ce qui concerne les résistances de polarisation $R_3$, il a été trouvé préférable de les brancher entre le point milieu de la résistance $R_1$ et le point milieu de la résistance $R_2$, plutôt que directement sur la grille de la source de chaque transistor, car ce montage équilibre les tensions de polarisation.

La figure 5 représente un exemple de réalisation selon une technologie dite linéaire d'un oscillateur de puissance selon l'invention.

Cette figure ne concerne que la structure active de l'oscillateur, vue de dessus, et le substrat sur lequel l'oscillateur est monté, ainsi que son environnement, tel que par exemple un guide d'onde ne sont pas représentés dans le seul but de simplifier cette figure.

La partie gauche de la figure 5 représente une première forme de réalisation, selon laquelle une pluralité de pastilles de transistors à effet de champ, 11 à 1 n, sont réunis par des liaisons aussi courtes que possible à une pluralité de lignes microbandes sur leur grille et leur source. Du côté des grilles des transistors à effet de champ, les microbandes 21, 22 . . . 2n sont déposées par des techniques de métallisation connues de l'homme de l'art sur un substrat diélectrique 8, dont les dimensions peuvent être très légèrement supérieures à celles du peigne de microbandes ainsi formé. Ces microbandes sont court-circuitées entre elles, sur leur extrémité opposée à celle qui est réunie à la grille d'un transistor, par une métallisation 6. Les résistances d'équilibrage de suppression de modes parasites $R_1$ à $R_{1n}$ sont déposées, par des méthodes telles que la sérigraphie, entre les dents du peigne métallique ainsi formé, et elles occupent les fentes séparant entre elles les microbandes 21, 22 . . . 2n. En face de cette première plaquette 8 supportant les microbandes de grilles se trouve une seconde plaquette 9, en diélectrique également, supportant les microbandes de source 51, 52 . . . 5n. Les résistances d'équilibrage et de suppression de modes parasites $R_2$ . . . à $R_{2n}$ sont également déposées par des méthodes telles que la sérigraphie et elles occupent la place dans les fentes entre les microbandes. De la même façon qu'en ce qui concerne le substrat 8, le substrat peut être sans inconvénient de dimensions très légèrement supérieures au peigne métallique ainsi formé.

Du côté des sources des transistors à effet de chemp 11 . . . 1n, il y a deux possibilités pour court-circuiter entre elles les microbandes de source 51, 52 . . . 5n. Une première possibilité est celle qui est représentée sur la partie gauche de la figure 5, et qui consiste en une simple métallisation 7, cette métallisation étant assimilable à un rectangle allongé ou à une microbande. Dans ce cas, la charge de sortie sur la source de l'oscillateur est l'impédance de rayonnement dans un guide d'onde par exemple. Un court-circuit mobile dans le guide d'onde, côté grille permet d'ajuster l'impédance ramenée sur la source: sa position normale est d'environ $\lambda_g/4$ des transistors, $\lambda_g$ étant la longueur d'onde guidée dans un guide d'onde.

Une seconde possibilité est représentée sur la partie droite de la figure 5: elle permet de sortir sur une ligne microbande 50 Ohms après une ou plusieurs transformations d'impédances supplémentaires. La plaquette 9 supporte alors un réseau de microbandes 51, 52 . . . 5n, reliées entre elles par des résistances d'équilibrage $R_2$ . . . $R_2$n, mais le court-circuit entre les microbandes et la sortie se fait par l'intermédiaire d'une ligne dont la section varie en un certain nombre d'étages, 71, 72, 73, sans que ce nombre ne limite la portée de l'invention, chaque étage assurant une transformation d'impédance. Une telle sortie est généralement utilisée pour une sortie sur coaxial.

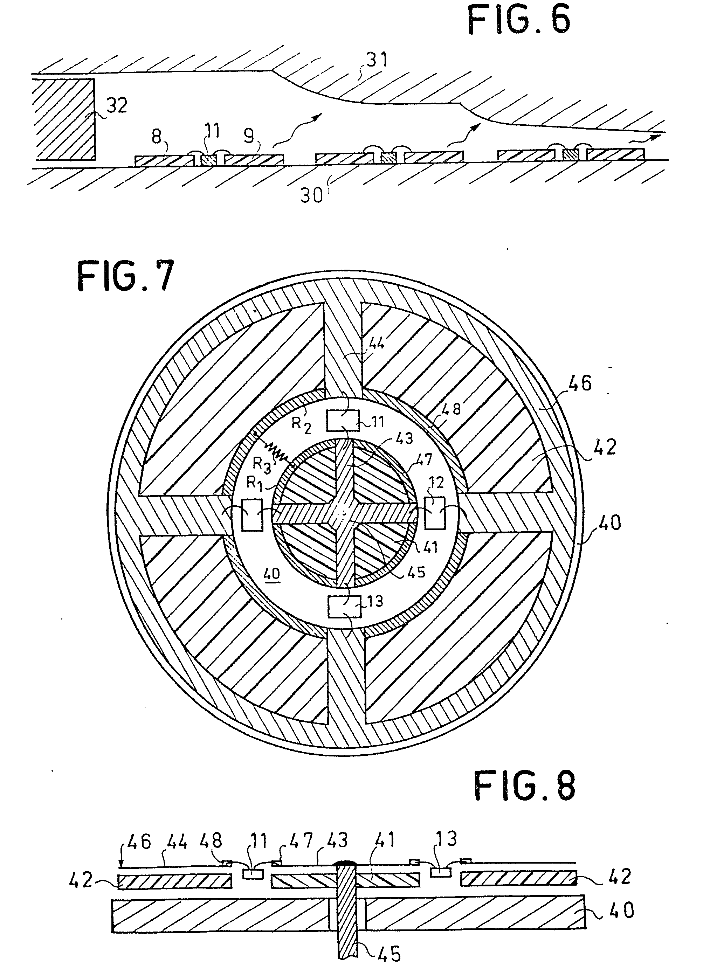

La figure 6 représente un exemple de couplage de plusieurs oscillateurs de puissance selon l'invention, dans un guide microonde. Sur cette figure, le guide d'onde est représenté de façon schématique par une paroi inférieure 30, une paroi supérieure 31, et un court-circuit réglable 32. Sur la paroi 30 du guide d'onde, sont fixés une pluralité d'oscillateurs selon l'invention, chacun de ceux-ci étant conforme à l'exemple décrit en figure 5, avec une sortie du type rayonnement dans un guide d'onde – c'est-à-dire celle représentée dans la partie gauche de la figure 5 –. La figure, vue en coupe, ne représente donc qu'un seul transistor de chaque oscillateur réuni par des liaisons courtes à deux microbandes supportées par les substrats 8 et 9. Comme sur les figures précédentes, la polarisation des oscillateurs n'a pas été représentée de façon à simplifier les figures, la polarisation étant un phénomène secondaire dans la description de l'invention. Les différents modules d'oscillateurs de puissance sont distants entre eux d'une longueur égale à $\lambda_g/2$. Le premier module oscillateur synchronise les suivants. L'impédance du guide d'onde décroît au fur et à mesure que l'on se rapproche de la sortie, pour assurer l'égalité des puissances fournies par chaque module, ce qui signifie que au moins la paroi 31 du guide d'onde, qui est opposée à la paroi 30 sur laquelle sont fixés les modules oscillateurs de puissance, présente une forme en escalier, chaque marche d'escalier étant à l'aplomb de la sortie de chaque module oscillateur, de façon à adapter l'impédance du guide d'onde.

La figure 7 représente un second exemple de réalisation d'un oscillateur selon l'invention selon une topologie circulaire. Le schéma de l'oscillateur étant donné en plan en figure 7, il est donné en coupe en figure 8, les deux figures 7 et 8 se complétant pour une lecture plus aisée.

Sur un support métallique 40, qui sert à la fois de masse électrique et de dissipateur thermique, sont fixées deux rondelles 41 et 42, en matériau diélectrique, concentriques. La rondelle centrale 41 est un substrat qui supporte un circuit en étoile gravée, sur lequel sont un certain nombre de bandes métallisées 43, qui correspondent aux microbandes 21 ou 51 de la figure 3. La rondelle extérieure 42, en forme de couronne, est un substrat qui supporte un circuit composé d'une part de bandes métalliques 44, qui correspondent aux microbandes 51 ou 21 de la figure 3. Au centre du substrat 41 se trouve en 45 la polarisation par un câble coaxial, qui correspond au court-circuit 6 ou 7 de la figure 3. A l'extérieur du substrat 42 en forme de couronne se trouve une métallisation 46 qui réunit entre elle les microbandes 44, et qui correspond au court-circuit 7 ou 6 de la figure 3. Des pastilles de transistors 11, 12, 13 . . . sont fixées par leur substrat sur l'embase métallique 40, le drain de chaque transistor étant ainsi relié à la masse, tandis que des fils de liaison les plus courts possibles réunissent la source et la grille de chaque transistor à effet de champ aux microbandes 43 et 44. Des dépôts résistifs 47 et 48 sont déposés sur un bord de chacune des deux rondelles de diélectrique et réunissent entre elles les microbandes 43 en ce qui concerne les dépôts 47 sur le substrat central 41, et les microbandes 44 en ce qui concerne les dépôts résistifs 48 sur le substrat en couronne 42. Ces dépôts résistifs correspondent aux résistances $R_1$ et $R_2$ entre grille d'une part et source d'autre part.

L'ambiguïté entre l'équivalence des microbandes 43 et 44, sur cette figure 7 et les microbandes 21 et 51 sur la figure 3 va être levée par l'explication des deux types d'utilisation envisageable pour cette topologie.

Dans un premier cas, les pastilles de transistors sont montées et connectées de telle façon que les sources sont reliées au circuit central sur le substrat 41 et les grilles sont reliées à la couronne extérieure sur le substrat 42. La sortie de l'amplificateur de puissance s'effectue alors par le coaxial central 45, et les microbandes 43 sont équivalentes aux microbandes 51 de la figure 3, tandis que les dépôts résistifs 47 sont équivalents aux résistances $R_2$ de cette même figure 3. De la même façon, puisque les grilles sont réunies au circuit sur la couronne extérieure 42, les microbandes 44 sont équivalentes aux microbandes 21 et les dépôts résistifs 48 sont équivalents aux résistances $R_1$ de la figure 3. Dans ce cas, les dimensions du circuit de la couronne extérieure fixent la fréquence d'oscillation. Dans cette disposition, les grilles des transistors 11, 12, 13 ... sont reliées chacune à une microbande de longueur quart d'onde $\lambda/4$, et toutes ces microbandes sont courtcircuitées entre elles par une métallisation 46: les grilles s'autopolarisent, ou fonctionnement «grille en l'air»: Il n'est pas nécessaire qu'il y ait une résistance de polarisation entre le circuit du côté des sources et le circuit du côté des grilles.

Dans un second cas, les sources des transistors sont reliées à la couronne extérieure 42 et les grilles des transistors sont reliées au circuit central 41. Dans ce cas, les microbandes 44 sont équivalentes aux microbandes 51, les microbandes 43 sont équivalentes aux microbandes 21, et les dépôts résistifs 48 et 47 sont équivalents aux résistances $R_2$ et $R_1$, respectivement, de la figure 3. La fréquence peut alors être ajustée par modification de l'impédance ramenée au niveau de coaxial, et la puissance est délivrée par rayonnement de la couronne extérieure 46. Dans ce dernier cas, le circuit extérieur peut être optimisé pour obtenir un diagramme de rayonnement souhaité en fonction de l'utilisation envisagée et, au lieu que la puissance soit rayonnée dans un guide d'onde, ce qui est un cas classique, le module ainsi constitué selon la figure 7 peut servir directement de module actif d'antenne à balayage pour radars, la phase étant assurée par synchronisation de l'oscillateur au niveau du coaxial. Dans ce second cas, puisque les sources sont reliées à la couronne de substrat extérieur 42, et qu'il n'est pas aisé d'assurer une polarisation par l'intermédiaire de la métallisation circulaire 46, la polarisation peut être assurée par le coaxial 45, qui est en relation avec le substrat intérieur 41: il s'agit alors du type de polarisation représenté en 3 sur la figure 1. Cette polarisation est assurée grâce à l'introduction d'une résistance $R_3$, qui peut être gravée ou rapportée, et dont un exemplaire est représenté sur la figure 7, cette résistance $R_3$ étant connectée entre deux parties médianes des résistances 47 et 48, qui correspondent respectivement aux résistances $R_1$ et $R_2$. Bien entendu il y a dans ce cas autant de résistances $R_3$ qu'il y a de transistors, soit une résistance $R_3$ entre chaque couple de résistances $R_1$–$R_2$.

La figure 8 a été représentée avec les différentes couches de matériaux constituant le module légèrement décolées entre elles de façon à en faciliter la lecture.

La description faite d'un oscillateur de puissance en s'appuyant sur 2, 3, ou 4 transistors ne limite pas la portée de l'invention, qui concerne la mise en parallèle d'une pluralité de transistors à effet de champ. La disposition circulaire, en particulier, se prête au couplage d'un plus grand nombre de transistors, par exemple 8.

L'oscillateur de puissance selon l'invention trouve son application dans tous les dispositifs électroniques nécessitant l'émission d'une onde à quelques GHz, ces dispositifs étant en particulier ceux des télécommunications, pour les faisceaux herztiens par exemple, ou ceux des radars par exemple.

**Revendications**

1. Oscillateur hyperfréquence de puissance, constitué par une pluralité d'oscillateurs élémentaires couplés en parallèle, caractérisé en ce que chaque oscillateur élémentaire comporte un transistor à effet de champ (11), monté en drain (D) commun à la masse, la source (S) étant reliée à une ligne microbande (51) de longueur quart d'onde $\lambda_g/4$, $\lambda_g$ étant la longueur d'onde guidée de l'oscillation, la grille (G) étant réunie à une ligne microbande (21) de longueur quart d'onde $\lambda_g/4$, les lignes microbandes (21, 22 ... 2n) de grille des oscillateurs élémentaires étant réunies (en 6) entre elles par leur extrémité opposée à celle qui est reliée à la grille, les lignes microbandes (51, 52 ... 5n) de source étant réunies (en 7) entre elles par leur extrémité opposée à celle qui est reliée à la source, ladite extrémité (7) constituant la sortie (O) de l'oscillateur de puissance, des résistances ($R_1$) connectées entre grilles et des résistances ($R_2$) connectées entre sources servant à l'équilibrage et à la suppression des oscillations parasites.

2. Oscillateur hyperfréquence de puissance selon la revendication 1, caractérisé en ce que, dans une configuration linéaire il comporte, supportés par un socle métallique, une pluralité de transistors à effet de champ (11, 12 ... 1n) et, d'une part, un substrat diélectrique (8) supportant une pluralité de lignes microbandes parallèles (21, 22 ... 2n), de longueur quart d'onde $\lambda_g/4$, une

extrémité de chaque ligne (21) étant reliée à la grille d'un transistor à effet de champ (11) et à la ligne microbande voisine (22) par une résistance d'équilibrage (R$_1$), les autres extrémités des lignes microbandes (21, 22 ... 2n) étant reliées entre elles par une métallisation (6), et, d'autre part, un substrat diélectrique (9) supportant une pluralité de lignes microbandes parallèles (51, 52 ... 5n), une extrémité de chaque ligne (51) étant reliée à la source d'un transistor à effet de champ (11) et à la ligne microbande voisine (52) par une résistance d'équilibrage (R$_2$), les autres extrémités des lignes microbandes (51, 52 ... 5n) étant reliées entre elles par une métallisation (7), qui constitue la sortie de l'oscillateur de puissance.

3. Oscillateur hyperfréquence de puissance selon la revendication 2, caractérisé en ce que la sortie (7) est adaptée en impédance au moyen d'une métallisation constituée d'une pluralité de plages (7, 71, 72 ...) dont chacune a des dimensions telles qu'elle constitue un étage de transformation d'impédance.

4. Oscillateur hyperfréquences de puissance selon la revendication 1, caractérisé en ce que, dans une configuration circulaire, il comporte, supportés par un socle métallique (40):

– un premier substrat diélectrique (41) circulaire supportant un circuit constitué par des lignes microbandes (43) gravées en étoile et par des résistances d'équilibrage (47)déposées sur le bord du substrat circulaire (41) et réunissant entre elles deux extrémités de lignes microbandes (43) voisines, l'extrémité centrale des lignes microbandes (43) étant connectée à une sortie coaxiale (45)

– une pluralité de transistors (11, 12 ... 1n) fixés sur le socle (40), en un cercle concentrique avec le premier substrat circulaire (41), chaque pastille de transistor étant fixée à l'aplomb d'une ligne microbande (43)

– un second substrat diélectrique (42), en forme de couronne concentrique avec le premier substrat (41), supportant un circuit constitué par des lignes microbandes (44) gravées reliant le bord interne au bord externe de la couronne et par des résistances d'équilibrage (48) disposées sur le bord interne du substrat (42) et réunissant entre elles deux extrémités de lignes microbandes (44) voisines, une métallisation (46) gravée sur le bord externe du substrat (42) réunissant entre elles les autres extrémités des lignes microbandes (44)

– les transistors étant de plus montés en drain commun par leur soudure sur le socle métallique (40) et ayant une première électrode réunie à une microbande (43) du substrat circulaire (41) et une deuxième électrode réunie à une microbande (44) du substrat en couronne (42).

5. Oscillateur hyperfréquences de puissance selon la revendication 4, caractérisé en ce que pour chaque transistor, la source étant réunie à une microbande (43) du substrat circulaire (41) et la grille réunie à une microbande (44) du substrat en couronne (42), la puissance émise par l'oscillateur est recueillie sur la sortie en coaxial central (45).

6. Oscillateur hyperfréquences de puissance selon la revendication 4, caractérisé en ce que, pour chaque transistor, la grille étant réunie à une microbande (43) du substrat circulaire (41) et la source réunie à une microbande (44) du substrat en couronne (42), la puissance émise par l'oscillateur est recueillie sur la métallisation (46) sur le bord externe du substrat en couronne (42), une résistance additionnelle (R$_3$) montée entre chaque résistance (47) du substrat circulaire (41) et la résistance correspondante (48) du substrat en couronne (42) assurant la polarisation de source.

**Patentansprüche**

1. Leistungs-Mikrowellenoszillator, gebildet aus mehreren, parallelgeschalteten Elementaroszillatoren, dadurch gekennzeichnet, dass jeder Elementaroszillator einen Feldeffekttransistor (11) umfasst, der in Drain-Basisschaltung mit Drain (D) an der Masse geschaltet ist, während die Source-Elektrode (S) an eine Mikrostreifenleitung (51) von der Länge einer Viertelwellenlänge $\lambda_g/4$, worin $\lambda_g$ die Wellenlänge der geführten Schwingungswelle ist, angeschlossen ist, wobei das Gate (G) mit einer Mikrostreifenleitung (21) von der Länge einer Viertelwellenlänge $\lambda_g/4$ angeschlossen ist, wobei ferner die Mikrostreifenleitungen (21, 22 ... 2n) der Gates der Elementaroszillatoren (bei 6) miteinander über dasjenige ihrer Enden verbunden sind, welches demjenigen gegenüberliegt, mit welchem das Gate verbunden ist, wobei die Mikrostreifenleitungen (51, 52 ... 5n) für die Source-Elektrode (bei 7) miteinander über dasjenige ihrer Enden verbunden sind, welches demjenigen gegenüberliegt, das mit der Source-Elektrode verbunden ist, wobei ferner dieses Ende (7) den Ausgang (O) des Leistungsoszillators bildet und Widerstände (R$_1$), die zwischen die Gates geschaltet sind, und Widerstände (R$_2$), die zwischen die Source-Elektroden geschaltet sind, zum Abgleich und zur Unterdrückung von Störschwingungen dienen.

2. Leistungs-Mikrowellenoszillator nach Anspruch 1, dadurch gekennzeichnet, dass er bei einer linearen Ausgestaltung von einem Metallsokkel getragen mehrere Feldeffekttransistoren (11, 12 ... 1n) umfasst sowie einerseits ein dielektrisches Substrat (8) aufweist, welches mehrere parallele Mikrostreifenleitungen (21, 22 ... 2n) von der Länge einer Viertelwellenlänge $\lambda_g/4$ trägt, wobei ein Ende jeder Leitung (21) mit dem Gate eines Feldeffekttransistors (1) und mit der benachbarten Mikrostreifenleitung (22) über einen Abgleichwiderstand (R$_1$) verbunden ist, während die anderen Enden der Mikrostreifenleitungen (21, 22 ... 2n) miteinander über eine Metallisierung (6) verbunden sind, und andererseits ein dielektrisches Substrat (9) aufweist, welches mehrere parallele Mikrostreifenleitungen (51, 52 ... 5n) trägt, wobei ein Ende jeder Leitung (51) mit der Source-Elektrode eines Feldeffekttransistors (11) und mit der benachbarten Mikrostreifenleitung (52) über einen Abgleichwiderstand (R$_2$) verbunden ist, während die anderen Enden der Mikrostreifenleitungen (51, 52 ... 5n) miteinander über eine Metallisierung (7) verbunden sind, welche den Ausgang des Leistungsoszillators bildet.

3. Leistungs-Mikrowellenoszillator nach Anspruch 2, dadurch gekennzeichnet, dass der Ausgang (7) impedanzmässig durch eine Metallisierung angepasst ist, welche aus mehreren Bereichen (7, 71, 72 ...) gebildet ist, wovon jeder derartige Abmessungen aufweist, dass er eine Impedanztransformatorstufe bildet.

4. Leistungs-Mikrowellenoszillator nach Anspruch 1, dadurch gekennzeichnet, dass er bei einer kreisrunden Ausgestaltung von einem Metallsockel (40) getragen umfasst:
– ein erstes kreisrundes dielektrisches Substrat (41), welches eine Schaltung trägt, die aus sternförmig gravierten Mikrostreifenleitungen (43) und aus Abgleichwiderständen (47) gebildet ist, welche am Rand des kreisrunden Substrates (41) aufgebracht sind und zwei Enden von benachbarten Mikrostreifenleitungen (43) miteinander verbinden, während das zentrale Ende der Mikrostreifenleitungen (43) jeweils mit einem Koaxialausgang (45) verbunden ist,
– mehrere auf dem Sockel befestigte Transistoren (11, 12 ... 1n), die einen Kreis bilden, der konzentrisch mit dem ersten kreisrunden Substrat (41) ist, wobei jedes Transistorplättchen in der Senkrechten einer Mikrostreifenleitung (43) befestigt ist,
– ein zweites dielektrisches Substrat (42), welches kranzförmig und konzentrisch mit dem ersten Substrat (41) ausgebildet ist sowie eine Schaltung trägt, die aus gravierten Mikrostreifenleitungen (44), welche den Innenrand mit dem Aussenrand des Kranzes verbinden, und aus Abgleichwiderständen (48) gebildet ist, die am Innenrand des Substrates (42) angeordnet sind und zwei Enden von benachbarten Mikrostreifenleitungen (44) miteinander verbinden, wobei eine am Aussenrand des Substrates (42) gravierte Metallisierung (46) die anderen Enden der Mikrostreifenleitungen (44) miteinander verbindet,
– wobei die Transistoren ferner in Drain-Basisschaltung geschaltet sind, indem sie auf dem Metallsockel (40) angelötet sind, sowie mit einer ersten Elektrode an eine Mikrostreifenleitung (43) des kreisrunden Substrats (41) und mit einer zweiten Elektrode an eine Mikrostreifenleitung (44) des kranzförmigen Substrats (42) angeschlossen sind.

5. Leistungs-Mikrowellenoszillator nach Anspruch 4, dadurch gekennzeichnet, dass bei jedem Transistor die Source-Elektrode an eine Mikrostreifenleitung (43) des kreisrunden Substrats (41) angeschlossen ist und das Gate an eine Mikrostreifenleitung (44) des kranzförmigen Substrats (42) angeschlossen ist, wobei die vom Oszillator abgegebene Leistung an dem zentralen Koaxialausgang (45) abgenommen wird.

6. Leistungs-Mikrowellenoszillator nach Anspruch 4, dadurch gekennzeichnet, dass bei jedem Transistor das Gate mit einer Mikrostreifenleitung (43) des kreisrunden Substrats (41) verbunden ist und die Source-Elektrode an eine Mikrostreifenleitung (44) des kranzförmigen Substrats (42) angeschlossen ist, wobei die von dem Oszillator abgegebene Leistung an der Metallisierung (46) am Aussenrand des kranzförmigen Substrates (42) abgenommen wird und wobei ein zusätzlicher Widerstand ($R_3$), der zwischen jedem Widerstand (47) des kreisrunden Substrats (41) und dem entsprechenden Widerstand (48) des kranzförmigen Substrats (42) angeordnet ist, die Source-Polarisation gewährleistet.

**Claims**

1. Microwave power oscillator, formed of a plurality of parallel connected elementary oscillators, characterized in that each elementary oscillator comprises a field effect transistor (11) mounted in commun drain (D) connected to ground, the source (S) being connected to a microstrip line (51) of a length equal to a quarter wavelength $\lambda_g/4$, $\lambda_g$ being the wavelength of the guided oscillation waves, the gate (G) being connected to a microstrip line (21) of a length equal to the quarter wavelength $\lambda_g/4$, the microstrip lines (21, 22 .. 2n) associated with the gates of the elementary oscillators being interconnected (at 6) by their respective end opposite to that which is connected to the gate, the microstrip lines (51, 52 ... 5n) associated with the sources being interconnected (at 7) by their respective end opposite to that which is connected to the source, said end (7) forming the output (O) of the power oscillator, resistors ($R_1$) connected between the gates and resistors ($R_2$) connected between the sources providing the balance and the suppression of parasitic oscillations.

2. Microwave power oscillator according to claim 1, characterized in that, in a linear configuration, it comprises, carried by a metallic base, a plurality of field effect transistors (11, 12 ... 1n) and, on the one hand, a dielectric substrate (8) carrying a plurality of parallel microstrip lines (21, 22 ... 2n) of a length equal to a quarter wavelength $\lambda_g/4$, one end of each line (21) being connected to the gate of a field effect transistor (11) and to the adjacent microstrip line (22) through a balancing resistor ($R_1$), the other ends of the microstrip lines (21, 22 ... 2n) being interconnected by a metallization (6), and, on the other hand, a dielectric substrate (9) carrying a plurality of parallel microstrip lines (51, 52 ... 5n), one end of each line (51) being connected to the source of a field effect transistor (11) and to the adjacent microstrip line (52) through a balancing resistor ($R_2$), the other ends of the microstrip lines (51, 52 ... 5n) being interconnected by a metallization (7) forming the output of the power oscillator.

3. Microwave power oscillator according to claim 2, characterized in that the output (7) is impedance adapted by means of a metallization formed of a plurality of zones (7, 71, 72 ...) each of which is dimensioned such that it forms an impedance transformation stage.

4. Microwave power oscillator according to claim 1, characterized in that, in a circular configuration, it comprises, carried by a metallic base (40):

— a first, circular dielectric substrate (41) carrying a circuit formed of microstrip lines (43) engraved in the shape of a star and by balancing resistors (47) deposited on the edge of the circular substrate (41) and interconnecting two ends of adjacent microstrip lines (43), the central end of the microstrip lines (43) being connected to a coaxial output (45),

— a plurality of transistors (11, 12 ... 1n) affixed on the base (40) forming a circle which is concentric with the first circular substrate (41), each transistor chip being affixed vertically from a microstrip line (43),

— a second dielectric substrate (42) shaped as a crown concentric with the first substrate (41) and carrying a circuit formed of engraved microstrip lines (44) connecting the inner edge to the outer edge of the crown and of balancing resistors (48) arranged on the inner edge of the substrate (42) and interconnecting two ends of adjacent microstrip lines (44), a metallization (46) engraved on the outer edge of the substrate (42) interconnecting the other ends of the microstrip lines (44),

— the transistors being further mounted in common drain by being soldered on the metallic base (40), and having a first electrode connected to a microstrip (43) of the circular substrate (41) and a second electrode connected to a microstrip (44) of the crown-shaped substrate (42).

5. Microwave power oscillator according to claim 4, characterized in that the source of each transistor is connected to a microstrip (43) of the circular substrate (41), the gate being connected to a microstrip (44) of the crown-shaped substrate (42), the power generated by the oscillator being collected at the central coaxial output (45).

6. Microwave power oscillator according to claim 4, characterized in that the gate of each transistor is connected to a microstrip (43) of the circular substrate (41), the source being connected to a microstrip (44) of the crown-shaped substrate (42), the power generated by the oscillator being collected at a metallization (46) on the outer edge of the crown-shaped substrate (42), an additional resistor ($R_3$) mounted between each resistor (47) of the circular substrate (41), and the corresponding resistor (48) of the crown-shaped substrate (42) ensuring the source polarization.

# FIG.1

# FIG.2

# FIG.3

# FIG.4

# FIG.5

# FIG. 6

# FIG. 7

# FIG. 8